Europäisches Patentamt

European Patent Office

Office européen des brevets

(19)

(11) Veröffentlichungsnummer: **0 149 117**
**B1**

(12)

# EUROPÄISCHE PATENTSCHRIFT

(45) Veröffentlichungstag der Patentschrift:
**01.06.88**

(51) Int. Cl.⁴: **H 03 J 7/18**

(21) Anmeldenummer: **84114987.5**

(22) Anmeldetag: **08.12.84**

(54) Automatisches Sendersuchverfahren und Suchempfänger zur Durchführung des Verfahrens.

(30) Priorität: **12.01.84 DE 3400859**

(43) Veröffentlichungstag der Anmeldung:
**24.07.85 Patentblatt 85/30**

(45) Bekanntmachung des Hinweises auf die Patenterteilung:
**01.06.88 Patentblatt 88/22**

(84) Benannte Vertragsstaaten:
**AT CH DE IT LI NL**

(56) Entgegenhaltungen:
**DE - A - 2 536 453**
**DE - A - 2 758 961**
**DE - B - 1 186 520**
**US - A - 4 352 208**
**US - A - 4 367 558**

(73) Patentinhaber: **Licentia Patent-Verwaltungs-GmbH,**
**Theodor-Stern-Kai 1, D-6000 Frankfurt/Main 70 (DE)**

(72) Erfinder: **Lange, Wolf Dietrich Dipl.-Ing., Kirchberger**
**Strasse 1, D-7910 Neu-Ulm (DE)**
Erfinder: **Müller, Klaus, Elchingerweg 6, D-7900 Ulm (DE)**

(74) Vertreter: **Schulze, Harald Rudolf, Dipl.-Ing. et al,**
**Licentia Patent-Verwaltungs-GmbH**
**Theodor-Stern-Kai 1, D-6000 Frankfurt/Main 70 (DE)**

## Beschreibung

Die Erfindung betrifft ein automatisches Sendersuchverfahren und einen Suchempfänger zur Durchführung eines solchen Verfahrens.

Automatische Suchempfänger sind für eine geforderte Nachweisempfindlichkeit durch ihre Suchgeschwindigkeit gekennzeichnet, die z.B. für das Erfassen kurzzeitiger Aussendungen auf unbekannten Frequenzen im Suchfrequenzbereich von Bedeutung ist.

Als Empfindlichkeit sind die Entdeckungswahrscheinlichkeit für ein definiertes ZF-Signal-Rauschverhältnis oder die Empfängereingangsspannung und die Falschalarmwahrscheinlichkeit als Vortäuschen von Kanalbelegungen in freien Kanälen (nur Rauschen) gemeinsam zu bewerten.

Zum Erreichen einer bestimmten Empfindlichkeit in der Belegungsentscheidung ist aufgrund der statistischen Schwankungen des Rauschens im Empfangskanal eine entsprechende Mittelungs- oder Messzeit erforderlich. Übliche Suchverfahren mit sequentieller Frequenzfortschaltung des Empfängers, bei denen Frequenzraster und Suchbandbreite der gewünschten Frequenzauflösung entsprechen, besitzen eine konstante Suchgeschwindigkeit, die sich aus der Messzeit und der Umschaltzeit des Empfangsteiles je Frequenzschritt ergibt. Ein derartiger Suchempfänger ist beispielsweise in der DE-A-27 58 961 beschrieben. Nachteilig daran ist, dass die Wahrscheinlichkeit, eine nur kurzzeitige Sendung zu erfassen, gering ist, da insbesondere bei nur wenigen belegten Kanälen im Suchbereich sehr viel Zeit für die Überprüfung unbelegter Kanäle verlorengeht und dadurch die Suchgeschwindigkeit klein bleibt.

Der vorliegenden Erfindung liegt die Aufgabe zugrunde, ein automatisches Sendersuchverfahren der im Oberbegriff des Patentanspruchs 1 genannten Art anzugeben, das in derartigen Fällen eine wesentlich höhere Suchgeschwindigkeit erlaubt, sowie einen Suchempfänger zur Durchführung eines solchen Verfahrens.

Das erfindungsgemässe Verfahren ist im Patentanspruch 1, der erfindungsgemässe Suchempfänger im Patentanspruch 5 beschrieben. Die Unteransprüche beinhalten vorteilhafte Ausführungen und Weiterbildungen der Erfindung.

Das erfindungsgemässe Suchverfahren ermöglicht in wenig belegten Frequenzsuchbereichen eine wesentlich höhere Suchgeschwindigkeit. Die Anzahl der erforderlichen Suchschritte bis zur Aufklärung eines Signals S in der Endbandbreite BBn entsprechend dem Auflösungsvermögen des Empfängers hängt von der Frequenzlage des Signals und der Verteilung mehrerer Signale im Suchintervall ab.

Wird angenommen, dass jeder Suchschritt unabhängig von der Bandbreite eine gleichlange Messzeit benötigt, ergibt sich eine Erhöhung der Suchgeschwindigkeit gegenüber dem sequentiellen Suchen mit gleichbleibender Bandbreite BBn aus dem Verhältnis der Anzahl ihrer erforderlichen Suchschritte.

In einem von Signalen freien Suchfrequenzbereich wird der maximale Gewinn an Suchgeschwindigkeit gegenüber dem sequentiellen Suchen als Verhältnis der Suchschrittanzahl $N_{BB1}/N_{BBn}$ gleich dem Bandbreitenverhältnis $BBn/BB1$ erreicht. Bei der bevorzugten binären Staffelung der Bandbreiten in n Stufen ist $BB1 = BBn \cdot 2^{(n-1)}$, so dass die Suchgeschwindigkeit um den Faktor $2^{(n-1)}$ erhöht wird.

Mit Zunahme der Belegungsdichte, noch abhängig von der Verteilung der Signale, nimmt das Verhältnis immer mehr ab und erfordert, wenn schliesslich alle Schritte mit der Endbandbreite ausgeführt werden müssen, eine höhere Schrittanzahl als das sequentielle Suchen. Das erfindungsgemässe Suchverfahren hat seine Vorteile also in wenig dicht belegten Bereichen, z.B. in Abschnitten der VHF-und UHF-Frequenzen.

Besonders vorteilhaft in Verbindung mit dem erfindungsgemässen Suchverfahren ist die Auswertung des Phasenspektrums innerhalb des jeweils eingestellten Frequenzintervalls zur Belegungserkennung, wie im Patentanspruch 2 beschrieben. Der Aufbau einer entsprechenden Belegungserkennungseinrichtung kann dem Anspruch 8 entnommen werden. Aus der DE-A-25 36 453 ist bereits ein ähnliches Verfahren sowie eine Anordnung zur Belegungserkennung eines Frequenzkanals bekannt.

Der besondere Vorteil der Auswertung des Phasenspektrums in Verbindung mit dem erfindungsgemässen Suchverfahren ergibt sich dadurch, dass die Entdeckungssicherheit auch bei negativen Signal/Rauschabständen, wie sie bei entsprechend hohen Bandbreiten auftreten können, weitgehend unabhängig von Schwankungen des Störpegels ist. Dies ermöglicht bei passender Wahl der jeweiligen Messzeit über das den Grad der Mitteilung bestimmende Bandbreite-Messzeit-Produkt eine konstante absolute Empfindlichkeit unabhängig von der Bandbreite. Dazu ist im allgemeinen erforderlich, dass bei den grösseren Bandbreiten etwas grössere Messzeiten zu wählen sind als bei den kleineren. Aber auch für den besonders einfachen Fall einer bandbreitenunabhängigen Messzeit wird man in vielen Fällen brauchbare Ergebnisse mit wenigen dB Empfindlichkeitsverlust bei der grössten Bandbreite erzielen können, wenn das Verhältnis von grösster zu kleinster Bandbreite nicht zu gross ist (z.B. nicht mehr als etwa 100 : 1).

Mit der mehr oder weniger von der Bandbreite unabhängigen Empfindlichkeit wird eine wichtige Voraussetzung für das erfindungsgemässe Suchverfahren erfüllt, denn ein Signal, das in der grössten Bandbreite nicht gefunden wird, ist für die weitere Suche verloren, da die kleineren Bandbreiten dann nicht mehr aktiviert werden. Bei einer Pegelschwellenanordnung ist die hohe Genauigkeit der Referenzschwelle, die für die Entdeckung von Signalen bei niedrigen oder negativen Signal/Rauschabständen mit entsprechend geringen Pegelunterschieden zwischen belegtem und unbelegtem Kanal erforderlich ist, im allgemeinen nicht zuverlässig zu realisieren.

Um dies zu erreichen, müsste der aktuelle Wert der Referenzschwelle bei jeder Belegungsmessung neu ermittelt werden, wie es prinzipiell beim Verfahren der Auswertung des Phasenspektrums der Fall ist.

Bei dem erfindungsgemässen Sendersuchverfahren erfolgt das Absuchen unbelegter Frequenzbereiche durch die grossen Frequenzschritte besonders schnell. Erst bei Feststellung einer Senderbelegung wird mit sukzessiv kleiner werdender Bandbreite die durch Spektrumsbreite bzw. Kanalraster bestimmte mögliche Auflösung erreicht.

Die Erfindung ist nachfolgend anhand eines Ausführungsbeispiels unter Bezugnahme auf die Abbildungen noch veranschaulicht. Dabei zeigt

Fig. 1 den Aufbau eines Suchempfängers
Fig. 2 den Ablauf des Suchverfahrens
Fig. 3 eine Ausführung der Belegungserkennungseinrichtung.

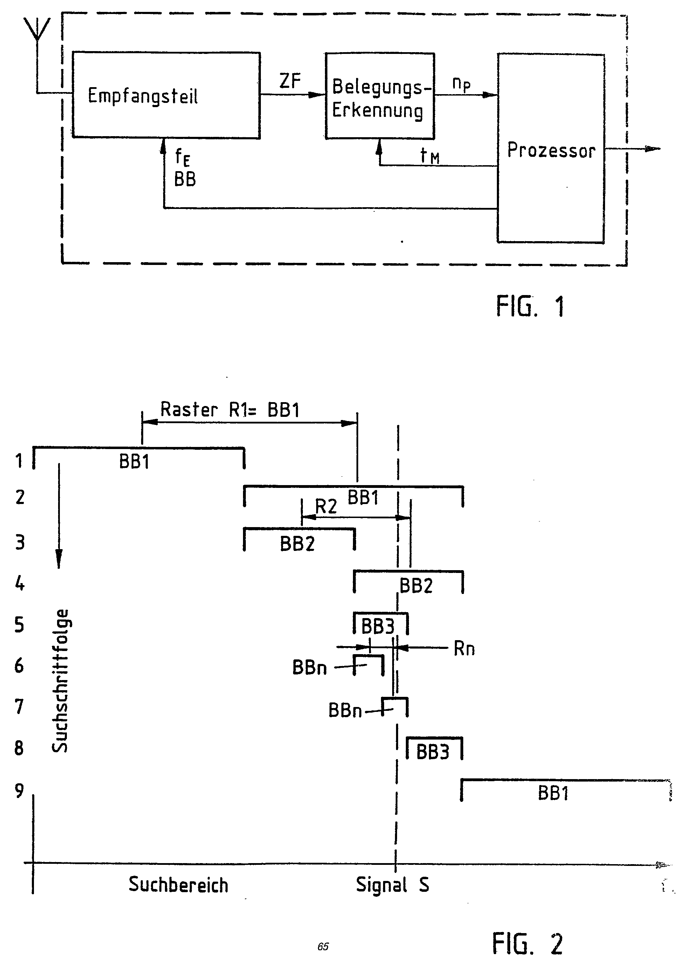

Fig. 1 zeigt den Aufbau des Suchempfängers. Der Empfangsteil besitzt eine Reihe von Suchfiltern, deren Bandbreiten im Verhältnis z.B. 2 : 1 gestuft sind. Dies ist bezüglich der erreichbaren Suchgeschwindigkeit die optimale Stufung, jedoch ist das Verfahren auch mit anders gestuften Bandbreiten anwendbar. Im Funktionsablauf des Suchempfängers stellt das Suchprogramm des Prozessors Pr in Folge die Empfangsfrequenz $f_E$ und die Suchbandbreite BB am Empfangsteil E ein, startet die Belegungserkennung BE für eine definierte Messzeit $t_M$, übernimmt deren gemessene Daten np, trifft die Entscheidung Kanal belegt/nicht belegt, von deren Ergebnis dann entsprechend dem Suchverfahren die neue Empfangsfrequenz $f_E$ mit evtl. geänderter Suchbandbreite BB für den nächsten Suchschritt bestimmt ist. Von hier ab wiederholt sich der Zyklus.

Zur Erläuterung des Suchverfahrens wird in Fig. 2 vereinfachend angenommen, dass nur ein Signal im Suchbereich vorhanden und das Schrittraster R, der Abstand der Filtermittenfrequenzen benachbarter Suchschritte derselben Bandbreite, gleich der jeweiligen Bandbreite BB eingestellt ist.

Im Normalfall der Praxis wird meist das Raster R kleiner als die Suchbandbreite BB eingestellt, um überlappende Suche zu erreichen.

Die Suche erfolgt mit einer von der Belegungsentscheidung im vorausgehenden Suchschritt festgelegten Suchbandbreite und einem jeder Bandbreite fest zugeordneten Schrittraster in der Weise, dass mit der grössten Suchbandbreite BB1 der Suchschritt 1 an der unteren Suchbereichsgrenze eingestellt und die Belegungserkennung gestartet wird. In Fig. 2 liegt das Signal S ausserhalb des Suchschrittes 1, es wurde keine Belegung gefunden und die Suche mit Schritt 2 wieder mit BB1 und R fortgesetzt. Im Schritt 2 liegt nun das Signal S, die Belegungsentscheidung ergibt Belegung und hat zur Folge, dass das Frequenzintervall des Schrittes 2 mit den Schritten 3 und 4 der Bandbreite BB2 im Raster R2 zur weiteren Aufklärung der genauen Frequenzlage des Signals S abgesucht wird. Schritt 3 ergab keine Belegung, deshalb Schritt 4 mit unveränderter BB2. Die weiteren Suchschritte 5 bis 7 erfolgen nach dem gleichen Prinzip, indem bei Nichtbelegung der nächste Suchschritt mit derselben, bei Belegung mit der nächst kleineren Bandbreite auszuführen ist, bis zu der der geforderten Frequenzauflösung entsprechenden Endbandbreite BBn. Das Nachsuchen beschränkt sich dabei immer auf das belegte Intervall der nächsthöheren Bandbreite. Im Beispiel Fig. 2 wird die Suche mit Schritt 8 des noch nicht auf Belegung überprüften oberen halben Intervalls des Schrittes 4 fortgesetzt. Damit ist das Intervall Schritt 2 lückenlos abgesucht. Ab Schritt 9 erfolgt die weitere Suche wieder mit der grössten Bandbreite BB1 im Suchbereich.

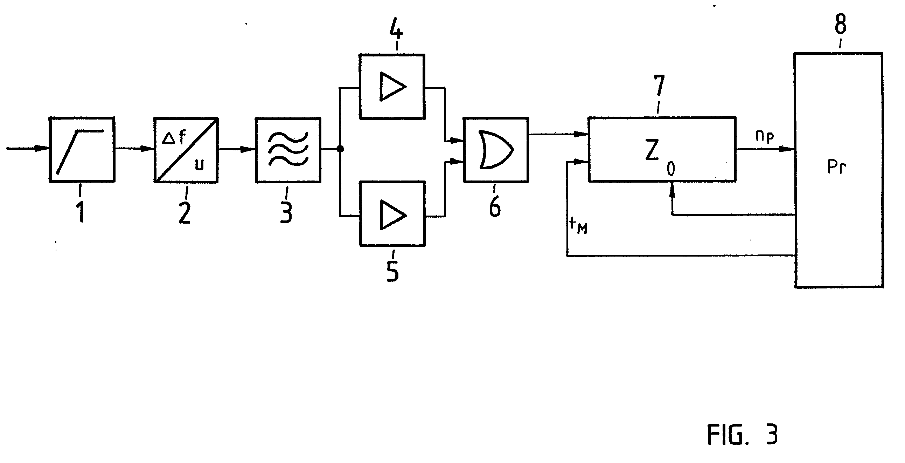

Fig. 3 zeigt eine bevorzugte Ausführungsform der Belegungserkennungseinrichtung. Das ZF-Signal wird in einem Amplitudenbegrenzer 1 begrenzt und einem Frequenzdiskriminator zugeführt. Das Ausgangssignal des Frequenzdiskriminators wird auf das Bandpassfilter 3 gegeben, das eine Frequenz- oder Phasenmodulation des Nutzsignals abtrennen soll. Das verbleibende Spektrum enthält dann überwiegend Rauschanteile, kann also näherungsweise als Mass für die Rauschleistung im ZF-Kanal herangezogen werden. Da die Gesamtleistung durch die Begrenzung festgelegt ist, erhält man somit die Aussage über den Rauschabstand. Die weitere Auswertung des Bandpassausgangssignals, das für Rauschen im Empfangskanal auch einem Rauschsignal im Zeitverlauf entspricht, erfolgt durch «Digitalisierung» mit Hilfe der beiden Spannungskomparatoren 4 und 5. Ihre Referenzschwellen sind je eine für positive und negative Signalanteile eingestellt. Für Rauschen besitzt das Auswertesignal eine Amplitudenverteilung mit maximaler mittlerer Amplitude, die an den Komparatorschwellen auch eine maximale Anzahl von Schwellüberschreitungen auslöst. Mit zunehmendem Signal/Rauschverhältnis im ZF-Kanal gehen die Amplituden der Auswertespannung und damit die Anzahl der Schwellüberschreitungen gegen null. In der Anzahl der Schwellüberschreitungen lässt sich somit zwischen Rauschen und Signal/Rauschabständen im Empfangskanal unter Berücksichtigung der jeweiligen ZF-Suchbandbreite unterscheiden. Die eigentliche Entscheidung über Kanal belegt/nicht belegt nimmt der Prozessor 8 vor, nachdem er den Zählerstand np aus dem Zähler 7 übernommen hat, der während der Messzeit die in 6 ODER-verknüpften Ausgangssignale der Komparatoren 4 und 5 auszählt. Zu Beginn einer neuen Messzeit stellt der Prozessor 8 den Zähler 7 auf 0 zurück.

Ist mit einer Pegelschwelle für die automatische Belegungserkennung die Ermittlung des Entscheidungskriteriums «Pegel des unbelegten Kanals» häufig schwierig, bereitet es im vorliegenden Verfahren der Auswertung des Phasenspektrums keine Probleme, mit Hilfe des Prozessors gewünschte definierte Entscheidungsschwellen zu eichen. Zu diesem Zweck wird der Empfangskanal über ein Break-in-Signal von der Antenne getrennt, so dass nur noch das Empfängereigenrauschen vorhanden ist, und eine Reihe von Messungen ausgeführt. Die Anzahl der Messungen berücksichtigt die statistische Verteilung der Einzelergebnisse und liefert mit bekannter statistischer Sicherheit die Pulszahlschwelle für eine definierte Falschalarmwahrscheinlichkeit $P_{FA}$.

Das vorliegende Verfahren der Eichung mit Rauschen ist ab einem Mindestpegel grösser der Ansprechschwelle des Amplitudenbegrenzers völlig pegelunabhängig und dadurch einfach durchführbar. Mit der Eichung der Falschalarmwahrscheinlichkeit $P_{FA}$ ist indirekt die Entdeckungswahrscheinlichkeit $P_D$ für einen gegebenen Signal/Rauschabstand festgelegt.

**Patentansprüche**

1. Automatisches Sendersuchverfahren zum Auffinden eines Senders, der auf einer beliebigen Frequenz innerhalb eines vorgegebenen Suchfrequenzbereichs sendet, durch schrittweises Verschieben eines Empfangsfrequenzintervalls und Untersuchen des jeweils empfangenen Frequenzbandes auf Belegung durch einen Sender und automatisches Weiterschalten auf eine andere Empfangsfrequenz bei fehlender Belegung, dadurch gekennzeichnet, dass der Suchfrequenzbereich in groben Frequenzschritten R1) entsprechend ersten Frequenzintervallen mit einer ersten Bandbreite (BB1) abgesucht wird, dass ein Intervall, in welchem eine Senderbelegung erkannt wird, in kleineren Frequenzschritten (R2) entsprechend zweiten Frequenzintervallen mit einer zweiten Bandbreite (BB2) abgesucht wird, und dass das Verfahren mit stufenweise kleiner werdenden Frequenzintervallen mit entsprechend stufenweise abnehmender Bandbreite fortgesetzt wird bis zum Erreichen einer kleinsten verfügbaren Bandbreite (BBn) entsprechend dem Frequenzauflösungsvermögen des Empfängers.

2. Verfahren nach Anspruch 1, dadurch gekennzeichnet, dass zur Belegungserkennung das Phasenspektrum innerhalb des jeweils eingestellten Frequenzintervalls ausgewertet wird durch Begrenzung und Frequenzdemodulation des in diesem Intervall empfangenen Signals, anschliessende Ausfilterung eines ausserhalb des eingestellten Frequenzintervalls liegenden Frequenzbandes, Integration der Amplituden über eine vorgegebene Messzeit, Vergleich des Integrationsergebnisses mit einem Schwellwert und Entscheidung auf Senderbelegung bei Unterschreiten des Schwellwerts.

3. Verfahren nach Anspruch 2, dadurch gekennzeichnet, dass zur Einstellung des Schwellwerts die Antenne vom Empfängereingang getrennt und das nur aufgrund des Empfängerrauschens entstehende Integrationsergebnis zur Ableitung eines Schwellwerts herangezogen wird.

4. Suchempfänger zur Durchführung des Verfahrens nach Anspruch 1, gekennzeichnet durch eine Filtereinrichtung mit mehreren stufenweise wählbar vorgegebenen Durchlassbandbreiten (BB1 bis BBn), eine Belegungserkennungseinrichtung (BE) und ein Steuergerät zum schrittweisen Fortschalten der Empfangsfrequenz ($f_E$) und zur Auswahl der Bandbreite (BB) nach Massgabe der Belegungsentscheidung der Belegungserkennungseinrichtung und des zuvor eingestellten Frequenzintervalls.

5. Suchempfänger nach Anspruch 4, dadurch gekennzeichnet, dass die mehreren Bandbreiten im Verhältnis 2:1 abgestuft sind.

6. Suchempfänger nach Anspruch 4 oder Anspruch 5, dadurch gekennzeichnet, dass die Frequenzschrittweite beim schrittweisen Fortschalten der Empfangsfrequenz bei gleichbleibender Bandbreite geringfügig kleiner ist als die Bandbreite, so dass sich benachbarte Frequenzintervalle gleicher Bandbreite überlappen.

7. Suchempfänger nach einem der Ansprüche 4 bis 6, gekennzeichnet durch einen Amplitudenbegrenzer (1), dem ein Frequenzdemodulator (2), ein Hoch- oder Bandpassfilter (3) sowie Einrichtungen zur Amplitudenintegration und zum Vergleich des Integrationsergebnisses mit einem Schwellwert nachgeschaltet sind, in der Belegungserkennungseinrichtung.

8. Suchempfänger nach Anspruch 7, dadurch gekennzeichnet, dass der Durchlassbereich des Hoch- oder Bandpassfilters (3) in Abhängigkeit von der in der Filtereinrichtung gewählten Bandbreite (BB) einstellbar ist.

9. Suchempfänger nach Anspruch 7 oder 8, dadurch gekennzeichnet, dass die Einrichtungen zur Amplitudenintegration mindestens einen Spannungskomparator, der bei Überschreiten seiner Ansprechschwelle einen Puls abgibt, und einen Zähler (7) zur Aufsummierung der Anzahl (np) der Überschreitungen innerhalb der Messzeit enthalten.

10. Suchempfänger nach Anspruch 9, dadurch gekennzeichnet, dass in zwei parallelen Signalwegen je einer von zwei Spannungskomparatoren (4, 5) mit betragsmässig gleichen Ansprechschwellen verschiedener Polarität angeordnet ist, deren Ausgangspulse denselben Zähler (7) beaufschlagen.

11. Suchempfänger nach einem der Ansprüche 4 bis 10, dadurch gekennzeichnet, dass zur Ablaufsteuerung und zur Belegtentscheidung durch Schwellwertvergleich ein Prozessor (8) vorgesehen ist.

**Revendications**

1. Procédé de recherche automatique d'un émetteur émettant sur une fréquence quelconque à l'intérieur d'une plage de fréquences données, par décalage graduel d'un intervalle de la fréquence reçue et par l'analyse de chacune des bandes de fréquences reçues afin de déterminer si elles sont assignées à un émetteur, avec commutation automatique de la recherche sur une autre fréquence en cas d'analyse négative, caractérisé par les faits que la plage de fréquences parcourue est d'abord interrogée en pas de fréquences grossièrement déterminés (R1) en fonction d'intervalles primaires dans une largeur de bande primaire (BB1), qu'un intervalle dans lequel une assignation d'émetteur a été détectée est ensuite interrogé à son tour en pas de fréquences plus réduits (R2) en fonction d'intervalles secondaires dans une largeur de bande secondaire (BB2), et que ce procédé est poursuivi en diminuant progressivement les intervalles de fréquences dans des largeurs de bandes elles aussi progressivement diminuées en conséquence jusqu'à atteindre la plus petite largeur de band disponible (BBn), selon la capacité de résolution de fréquence du récepteur.

2. Procédé selon la revendication 1, caractérisé par le fait que la reconnaissance de l'assignation du spectre des phases est analysée à l'intérieur de l'intervalle de fréquence parcouru en délimitant et démodulant la fréquence du signal perçu dans cet intervalle, avec filtrage coupe-bande consécutif d'une bande de fréquences à l'extérieur de l'intervalle de fréquence réglé, intégration des amplitudes durant un temps de mesure donné, comparaison des résultats de cette intégration par rapport à une valeur-seuil déterminée et prise de décision finale quant à l'assignation à un émetteur si cette valeur-seuil est sous-dépassée.

3. Procédé selon la revendication 2, caractérisé par le fait que, pour déterminer la valeur-seuil, l'antenne à l'entrée du récepteur est séparée et que seul le résultat de l'intégration provenant du bruit du récepteur est pris en ligne de compte pour en déduire cette valeur-seuil.

4. Récepteur de recherche pour la réalisation du procédé selon la revendication 1, caractérisé par un dispositif de filtrage avec plusieurs largeurs de bandes passantes (BB1 à BBn), prédéterminées et choisissables par échelons, un dispositif de reconnaissance d'assignation (BE) et un appareil de commande pour la commutation pas à pas de la fréquence de réception ($f_E$) et de la sélection de la largeur de bande (BB) en fonction de la décision prise par le dispositif de reconnaissance d'assignation sur l'intervalle de fréquence préalablement réglé.

5. Récepteur de recherche selon la revendication 4, caractérisé par le fait que toutes les largeurs de bandes sont échelonnées sur un rapport dégressif 2:1.

6. Récepteur de recherche selon l'une des revendications 4 ou 5, caractérisé par le fait que, à une largeur de bande demeurant constante lors de la commutation d'un pas de fréquence de réception à l'autre, le pas de fréquence est négligemment plus petit que la largeur de bande, de façon à ce que des intervalles de fréquences voisins de largeur de bande identique se chevauchent.

7. Récepteur de recherche selon l'une des revendications 4 à 6, caractérisé par le fait que l'écrêteur (1) équipant le dispositif de reconnaissance d'assignation est lui-même succédé d'un démodulateur de fréquences (2), d'un filtre passe-haut ou passe-bande (3), ainsi que de dispositifs servant à l'intégration de l'amplitude et à la comparaison du résultat de cette intégration avec une valeur-seuil déterminée.

8. Récepteur de recherche selon la revendication 7, caractérisé par le fait que la plage de réponse du filtre passe-haut ou passe-bande (3) est réglable en fonction de la largeur de bande (BB) choisie à l'intérieur du dispositif de filtrage.

9. Récepteur de recherche selon l'une des revendications 7 ou 8, caractérisé par le fait que les équipements servant à l'intégration de l'amplitude comportent au moins un comparateur de tension qui, au dépassement d'un seuil d'excitation donné, émet une impulsion, et un compteur (7) servant à totaliser le nombre (np) de dépassements enregistrés lors du temps de mesure.

10. Récepteur de recherche selon la revendication 9, caractérisé par le fait que les deux voies de signaux parallèles sont munies chacune d'un des deux comparateurs de tension (4, 5), avec un seuil d'excitation de valeur identique mais de polarité différente, comparateurs dont les impulsions de sortie excitent le même compteur (7).

11. Récepteur de recherche selon l'une des revendications 4 à 10, caractérisé par le fait qu'il est prévu un processeur (8) pour le contrôle du déroulement du fonctionnement et pour la prise de décision quant à l'assignation par la comparaison de valeurs-seuils. ———

**Claims**

1. Method for the automatic search of a transmitter to locate a transmitter which transmits at any frequency whithin a predetermined search frequency range by stepwise shifting of a receiving frequency interval and investigation of the respectively received frequency band as to occupancy by a transmitter and automatic switching to another receiving frequency in the case of unoccupancy, characterized in that the search frequency range is searched in large frequency steps (R1) corresponding to first frequency intervals with a first bandwidth (BB1), in that an interval in which occupancy by a transmitter is detected is searched in smaller frequency steps (R2) corresponding to second frequency intervals with a second bandwidth (BB2), and in that the method with stepwise decreasing frequency intervals with correspondingly stepwise decreasing bandwidth is continued until a smallest available bandwidth (BBn) corresponding to the frequency resolution capacity of the receiver is reached.

2. Method as defined in Claim 1, characterized in that in order to detect occupancy, the phase spectrum within the respectively set frequency interval is evaluated by limitation and frequency demodulation of the signal received in this interval, subsequent filtering-out of a frequency band located outside of the set frequency interval, integration of the amplitudes over a predetermined measuring time, comparison of the integration result with a threshold value and decision as to transmitter occupancy if the result falls short of the threshold value.

3. Method as defined in Claim 2, characterized in that in order to set the threshold value, the antenna is separated from the receiver input and the integration result based only on the receiver noise is used to derive a threshold value.

4. Searching receiver for performing the method as defined in Claim 1, characterized by a filter device with several stepwise selectably predetermined passband widths (BB1 to BBn), an occupancy detecting device (BE) and a control device for stepwise switching of the receiving frequency ($f_E$) and for selecting the bandwidth (BB) in accordance with the decision of the detecting device as to occupancy and with the previously set frequency interval.

5. Searching receiver as defined in Claim 4, characterized in that the several bandwidths are graduated in the ratio of 2:1.

6. Searching receiver as defined in Claim 4 or Claim 5, characterized in that the frequency step width during stepwise switching of the receiving frequency, with constant bandwidth, is slightly smaller than the bandwidth, with the result that adjacent frequency intervals of the same bandwidth overlap.

7. Searching receiver as defined in one of Claims 4 to 6, characterized in that an amplitude limiter (1), followed by a frequency demodulator (2), a high-pass or band-pass filter (3) and devices for the amplitude integration and for comparison of the integration result with a threshold value, in the occupancy detecting device.

8. Searching receiver as defined in Claim 7, characterized in that the pass band of the high-pass or band-pass filter (3) can be set in dependence upon the bandwidth (BB) selected in the filter device.

9. Searching receiver as defined in Claims 7 or 8, characterized in that the devices for the amplitude integration comprise at least one voltage comparator which generates a pulse when its response threshold is exceeded, and a counter (7) for adding up the number (np) of times it is exceeded within the measuring time.

10. Searching receiver as defined in Claim 9, characterized in that one of two voltage comparators (4, 5) whose response thresholds are of identical value and different polarity and whose output pulses are fed to the same counter (7) is arranged in each of two parallel signal paths.

11. Searching receiver as defined in one of Claims 4 to 10, characterized in that a processor (8) is provided for sequential control and for making a decision as to occupancy by means of threshold value comparison.

FIG. 1

FIG. 2

FIG. 3